# EUROPEAN PATENT SPECIFICATION

(11) **EP 4 100 764 B1**
(45) Date of publication and mention of the grant of the patent: **25.11.2026**
(21) Application number: 21703701.9
(22) Date of filing: 05.02.2021
(51) Int. Cl.: G01S 7/481, G01S 17/42, G01S 17/88, G01S 17/89, G02B 5/20, G02B 26/08, G02B 26/10, G01J 1/04, G01J 1/42, H04N 9/31, H10F 30/225, H10F 77/30, H10F 77/40

(54) **A LIGHT PIXEL PROJECTION MODULE**
LICHTBILDPUNKT-PROJEKTIONSMODUL
MODULE DE PROJECTION DE PIXEL LUMINEUX

(30) Priority: 06.02.2020 DE 102020201453
(43) Date of publication of application: 14.12.2022
(73) Proprietor: ams-OSRAM International GmbH, 93055 Regensberg (DE)
(72) Inventor: MAZZILLO, Massimo Cataldo, 22335 Hamburg (DE); RAMCHEN, Johann, 93345 Hausen (DE); MARFELD, Jan, 93055 Regensburg (DE)
(74) Representative: impuls legal PartG mbB
(86) International application number: PCT/EP2021/052819
(87) International publication number: WO 2021/156446

(56) References cited:
- EP-A1- 3 301 509
- US-A1- 2015 116 672

## Description

The present disclosure pertains to a light pixel projection module for integration into an electronic device, the light pixel projection module being adapted to emit pixels of light that are to be projected onto a surface, the light pixel projection module comprising:
- a light pixel generating assembly including a pixel light source;
- a light pixel projection assembly for projecting a light pixel generated by the light pixel generating assembly; and
- an optical time-of-flight - ToF - measurement assembly for measuring a distance between the projection module and an external object,
the ToF measurement assembly including:
a) a ToF light source for emitting light, which is to be directed onto the external object and reflected off the external object;
b) a beam splitting optical device for splitting an incident light beam into a reflected main beam component and a transmitted and attenuated secondary beam component; and
c) an APD-based ToF photodetector for light detection.

Such a light pixel projection module is known from document US 2019/0310489 A1.

This known solution has the drawback that it needs complex and power-consuming fast electronics 124, 170 to synchronise the photodetection with the driving of the IR laser 510 during ToF measurements.

A similar image projection module is described in EP 3301509 A1, featuring a lens that splits incident light into an internally reflected secondary component and a transmitted main component.

US 2015/0116672 A1 describes a scanning laser projection system with light from a plurality of light sources combined into a modulated light beam, and incorporating a plurality of photodetectors for testing, verifying and calibrating the operation of the laser light sources within the system.

An object of the present disclosure is therefore to provide a light pixel projection module with simple and power-saving ToF measurement capabilities.

According to the present invention, this object is achieved with the light pixel projection module according to claim 1.

Thanks to the beam splitting optical device that acts, according to the invention, also as the light pixel projection assembly of the light pixel projection module, a small part of the ToF light beam is diverted onto the ToF photodetector when it leaves the module. The detection of this secondary beam component by the ToF photodetector can then be used as the trigger for the necessary time measurement. Accordingly, one can dispense with the complicated synchronising electronics of the prior art.

According to preferred embodiments, the projection module of the present disclosure may include one, several or all of the following features, in all technically possible combinations:
- the beam splitting optical device is a layer stack with an upper mirror section acting as a largely reflecting mirror, and a lower light attenuating section arranged underneath the upper mirror section;
- the layer stack is deposited over the active surface area of the ToF photodetector;
- the upper mirror section is an optical longpass filter with a cutoff wavelength that is higher than the maximum wavelength of the light beams emitted by the ToF light source such that the secondary beam component of a light beam split by the beam splitting optical device amounts to no more than 5% of the light beam's overall intensity;
- the lower light attenuating section is a neutral density filter, preferably with a fractional transmittance of no more than 0.01%;
- a package, which houses the elements of the projection module, the ToF light source and the ToF photodetector thus sharing the same package;
- a photodetector assembly for detecting a drift in the irradiance of the pixel light source and/or the ToF light source;
- the photodetector assembly includes one or more silicon photomultipliers;
- the beam splitting optical device covers both the photodetector assembly and the ToF photodetector;
- the ToF photodetector includes at least one single photon avalanche diode or SPAD;
- the ToF photodetector consists of a single SPAD and the ToF measurement assembly further comprises a ToF light scanning device for scanning the main beam component over the external object to obtain a 3D image thereof.

The present disclosure also relates to an image projection device for projecting a pixelated image onto a surface, the image projection device including a projection module as defined above and a light scanning module for distributing the light pixels projected by the projection module onto different parts of the surface, thus creating the pixelated image.

The present disclosure also relates to a method of making ToF measurements using a projection module as defined above.

Preferred embodiments of the present disclosure will now be described in detail with reference to the accompanying drawings, in which:
Figure 1 is a functional block diagram of a first embodiment of a light pixel projection module according to the present disclosure;
Figure 2 is a functional block diagram showing the different elements of the supply and monitoring electronics of the projection module of figure 1;
Figures 3a and 3b are perspective views of a possible structural implementation of the first embodiment of figures 1 and 2; and
Figure 4 is a functional block diagram of a second embodiment of the light pixel projection module according to the present disclosure.

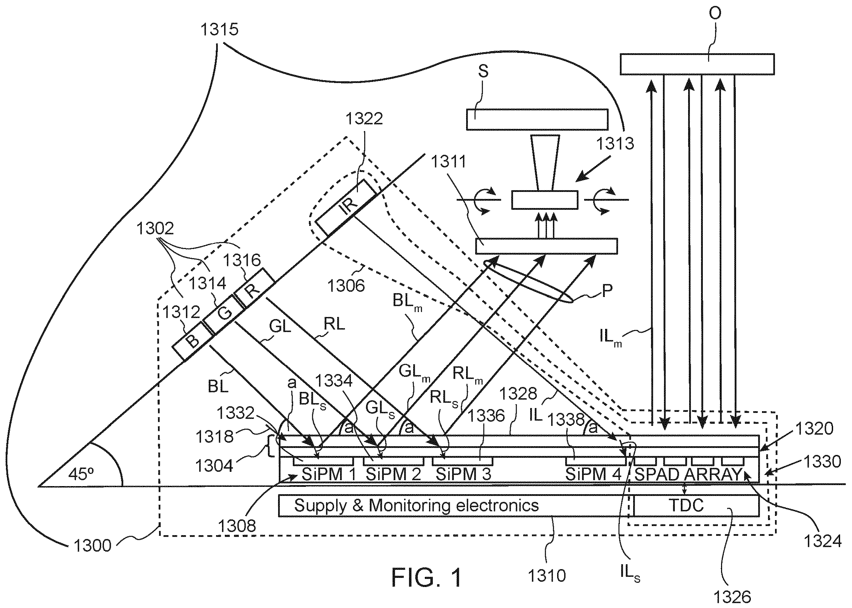

Figure 1 shows a first embodiment 1300 of the light pixel projection module according to the present disclosure. The light pixel projection module 1300 is delimited by the dashed polygon.

The light pixel projection module 1300 is a device that can be used to project changing light beams onto a screen to create pixels of an image for entertainment or professional applications. It is an optoelectronic component, which can be integrated into an electronic device, such as a smart phone, a wearable or tablet computer.

The light pixel projection module 1300 is adapted to emit pixels of light P that are to be projected onto a surface S.

The light pixel projection module 1300 comprises a light pixel generating assembly 1302, a light pixel projection assembly 1304, an optical time-of-flight measurement assembly 1306 (delimited by the dashed envelope), a photodetector assembly 1308 and supply and monitoring electronics 1310.

In the present example, the light pixel generating assembly 1302 consists of three laser diodes 1312, 1314 and 1316. The first laser diode 1312 is a blue laser and emits light BL at wavelength of e.g. 475 nm. The second laser diode 1314, is a green laser and emits light GL at a wavelength of e.g. 515 nm. The third laser diode 1316 in a red laser and emits light RL at a wavelength of e.g. 635 nm. The power of each laser diode may be up to 50 mW. Preferably, each laser diode emits intermittent individual light pulses with a duration of e.g. 2 ns (full width at half maximum, or FWHM). The three laser diodes 1312, 1314 and 1316, and thus the light pixel generating assembly 1302 may together be qualified as a pixel light source.

In figure 1, the light pixel projection assembly 1304 is implemented as a layer stack with an upper mirror section 1318 and a lower light attenuating section 1320 arranged underneath the upper section 1318. In the present example, the layer stack 1304 is deposited on top of the photodetector assembly 1308. The upper mirror section 1318 may be an optical longpass filter.

This longpass filter 1318 may be implemented in multilayer coating technology using e.g. silicon dioxide and titanium dioxide. The lower light attenuating section 1320 may be a neutral density filter, preferably with a fractional transmittance of no more than 0.01%. The lower light attenuating section 1320 may be implemented as a metal layer filter (e.g. based on aluminium) with micrometric area apertures.

The optical time-of-flight (TOF) measurement assembly 1306 is configured for measuring distances between the projection module 1300 and an external object O. The TOF measurement assembly 1306 includes a TOF light source 1322, a beam splitting optical device 1304, an avalanche photodiode (APD) based TOF photodetector 1324, and TOF measurement electronics 1326.

The TOF light source 1322 is configured to emit light IL, which is to be directed onto the external object O, and reflected off the external object O. Preferably, the TOF light source 1322 is an infrared (IR) laser diode. The infrared laser diode 1322 may emit light at a wavelength of around 905 nm. The power of the infrared laser diode 1322 may be up to 1 to 10 W, but preferably is of the order of 50-100 mW. The infrared laser diode 1322 may in particular emit light pulses with a duration of around 2 ns (full width at half maximum, FWHM). In the present embodiment, all four laser diodes 1312, 1314, 1316 and 1322 are grouped together and form a multi-wavelength laser illumination block. Having all light sources of the projection module 1300 as a group in one place simplifies the setup of the module and the control of the light sources.

The pixel light source 1302 (i.e. the red, green and blue lasers) and the time-of-flight light source 1322 (i.e. the IR laser) are both oriented with respect to the layer stack 1304 such that the light beams BL, GL, RL and IL emitted by those light sources hit the outer surface 1328 of the layer stack 1304 at an angle a of around 45°.

In the embodiment shown in figure 1, the light pixel projection assembly (i.e. the layer stack) 1304 also acts as a beam splitting optical device. This means that the layer stack 1304 splits an incident light beam, for example the light beam IL, into a reflected main beam component ILm and a transmitted and attenuated secondary beam component ILs. More precisely, the layer stack 1304 is arranged in the optical path of light beams emitted by the TOF light source 1322 and the pixel light source 1302 such that it splits each light beam (e.g. BL) into a main beam component (BLm) leaving the module 1300 and a secondary beam component (BLs) remaining within the module 1300 and hitting the TOF photodetector 1324 or the photodetector assembly 1308. To that effect, the upper mirror section 1318 acts as a largely reflecting mirror. As mentioned above, the largely reflecting mirror 1318 may be an optical longpass filter. Its cut-off wavelength is higher than the maximum wavelength of the light beams IL emitted by the TOF light source 1322. Since the time-of-flight light source 1322 typically is an infrared light source, this means that the optical longpass filter 1318 reflects virtually all of the light, regardless of whether it comes from the time-of-flight light source 1322 or the pixel light source 1302. The secondary beam components ILs, BLs, GLs and RLs of the light beams IL, BL, GL and RL split off by the layer stack 1304 may amount to no more than 5% of the light beams' overall intensity.

The TOF photodetector 1324 is arranged beneath the layer stack 1304. In the present example, the photodetector assembly 1308 and the TOF photodetector 1324 are integrated into a single monolithic photodetector chip 1330. The layer stack 1304 is deposited over the entire top surface of the photodetector chip 1330 and thus over the active surface areas of the TOF photodetector 1324 and of the photodetector assembly 1308. In other words, the layer stack 1304 covers both the photodetector assembly 1308 and the TOF photodetector 1324.

In the first embodiment of figure 1, the TOF photodetector 1324 is implemented as an array of single photon avalanche diodes (SPADs). The SPAD array 1324 may have a total of 64 x 64 pixels with independent outputs.

The TOF measurement electronics 1326 for reading out the signals delivered by the SPAD array 1324 may be a time-to-digital converter or TDC.

The photodetector assembly 1308 may comprise four silicon photomultipliers (SiPMs) 1332, 1334, 1336 and 1338. Each silicon photomultiplier is associated with one of the lasers 1312, 1314, 1316 and 1322. The first silicon photomultiplier 1332 is provided to monitor the irradiance of the blue laser 1312. The second silicon photomultiplier 1334 is provided to monitor the irradiance of the green laser 1314. The third silicon photomultiplier 1336 is provided to monitor the irradiance of the red laser 1316. The fourth silicon photomultiplier 1338 is provided to monitor the irradiance of the infrared laser 1322. All four silicon photomultipliers may be of the same type. Alternatively, each SiPM may have its own specific design, which is optimised for light detection in the relevant colour.

In figure 1, the four silicon photomultipliers 1332 to 1338 are arranged next to and flush with each other. The arrangement is such that, when a blue light beam BL is emitted by the blue laser 1312 and split by the beam splitter 1304, the secondary beam component BLs hits the first silicon photomultiplier 1332, when a green light beam GL is emitted by the green laser 1314 and split by the beam splitter 1304, the secondary beam component GLs hits the second silicon photomultiplier 1334, when a red light beam RL is emitted by the red laser 1316 and split by the beam splitter 1304, the secondary beam component RLs hits the third silicon photomultiplier 1336, and when an infrared light beam IL is emitted by the infrared laser 1322 and split by the beam splitter 1304, the secondary beam component ILs hits the fourth silicon photomultiplier 1338.

The purpose of the photodetector assembly 1308 is to detect a potential drift in the irradiance of the laser light sources. The four silicon photomultipliers 1332 to 1338 may have 10 x 10 pixels each and may have multiplexed outputs.

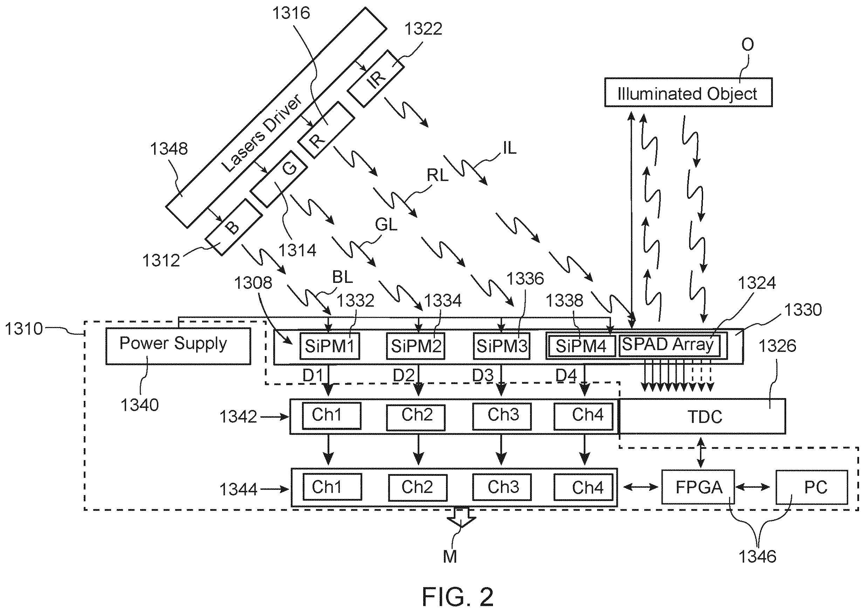

The supply and monitoring electronics 1310 is shown in more detail in figure 2 and identified therein by a dashed polygon. The purpose of the supply and monitoring electronics 1310 is to supply the photodetector assembly 1308 and the TOF photodetector 1324 with the electric power that is necessary for their operation and also to process the output signals D1 to D4 delivered by the four silicon photomultipliers 1332 to 1338. To that effect, the supply and monitoring electronics 1310 includes a power supply 1340, a discriminator stage 1342, a converter stage 1344 and a processing stage 1346. As indicated by the arrows, the power supply 1340 provides the necessary operating voltage individually to the first three silicon photomultipliers (blue, green and red) 1332, 1334 and 1336. The fourth silicon photomultiplier 1338 and the SPAD array 1324 form an integrated pair and are jointly powered by the power supply 1340.

In the present example, both the discriminator stage 1342 and the converter stage 1344 have four individual channels for the four individual signals D1 to D4 of the four silicon photomultipliers. The discriminator stage 1342 acts as a thresholder that removes low-level artefacts from the output signals D1 to D4. The purpose of the converter stage 1344, which follows the discriminator stage 1342, is to count or integrate the signals. Accordingly, the converter stage 1344 may be a counter or analogue to digital converter (ADC). The output of the converter stage 1344 is then used to monitor the intensity or irradiance of the lasers, as represented by the arrow M in figure 2. If there is a drift in the intensity of the light delivered by the lasers, one may then take corrective action by adjusting the operation of the lasers driver 1348. In this way, one can ensure an optimal brightness of the projected images, which are obtained with the help of the projection module 1300.

The projection module 1300 of figures 1 and 2 operates as follows:
The red, green, blue and infrared lasers emit very fast, high-power light pulses RL, GL, BL and IL. Most of the laser light is reflected by the layer stack 1304. The red, green and blue light reflected by the layer stack 1304 is used for laser projection. To this effect, the reflected components BLm, GLm and RLm may be shaped by a beam shaper 1311 and scanned over e.g. a screen S by a light scanning module 1313. The light scanning module 1313 may for example be a micro-electromechanical system or MEMS with a scanning mirror. In this way, one obtains a pixelated image on the surface of the screen S. The projection module 1300 and the light scanning module 1313 together form an image projection device 1315. In this image generating process, pixels P are projected by the layer stack 1304 out of the projection module 1300.

A small part of the light emitted by the four lasers is transmitted and attenuated by the layer stack 1304. This small part reaches the four silicon photomultipliers 1332 to 1338 and the SPAD array 1324. The red, green, blue and infrared laser light transmitted by the layer stack 1304 is monitored at single pulse level by the four independent silicon photomultipliers. In case there is an unwanted drift in the intensity of the pulses emitted by the red, green and/or blue laser, the control of the lasers driver 1348 is adjusted accordingly to correct the brightness of the image projected with the help of the projection module 1300 onto the screen S.

Optionally, the fourth silicon photomultiplier 1338 may also be used to detect stray infrared light inside the projection module 1300, for example, during the time intervals between the detection of consecutive infrared laser pulses by the fourth silicon photomultiplier 1338. This measurement of the amount of stray infrared light and thus of the IR noise present in the projection module 1300 may be used to improve the signal-to-noise ratio and/or the accuracy of the time-of-flight measurements.

The time-of-flight measurements work as follows: the secondary component ILs of the infrared light that reaches the SPAD array 1324 triggers the time acquisition for each pixel of the SPAD array. Concurrently, the reflected main beam component ILm leaves the module and heads towards the external object O. Infrared light from the main beam component ILm then reflects off the external object O and returns back to the SPAD array 1324. This generates the respective stop signals for each pixel of the SPAD array and the time acquisition is completed. The resulting time-of-flight measurements can be used to construct a 3D image of the surface of the external object O. Preferably, the return of infrared light from the external object O triggers a new round of time acquisitions, which is stopped once the infrared light has travelled back and forth for a second time between the SPAD array 1324 and the external object O. This process can be repeated several times in a closed-loop.

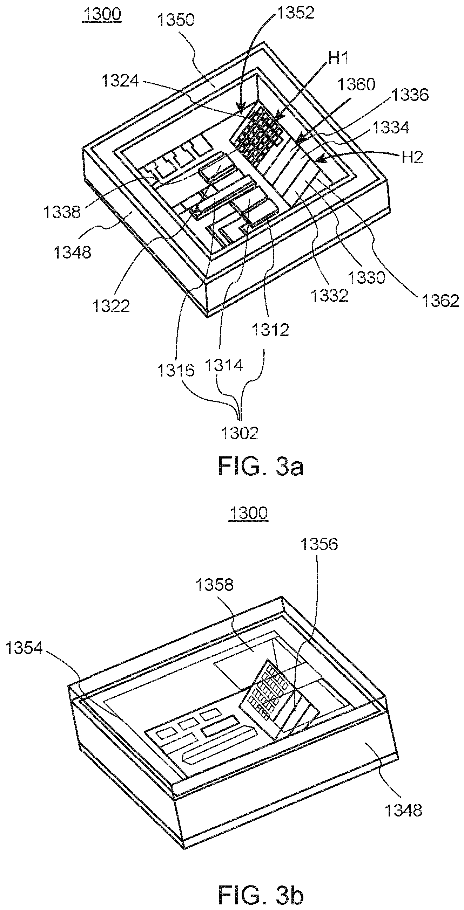

We will now turn to figures 3, which show a possible structure of the projection module 1300 of the present disclosure. As shown in figures 3, all the elements of the projection module 1300 may be integrated into a single package 1348. The package 1348 may have a cuboid shape. It may be made of ceramic or silicone. In the shown example, package 1348 has an outer rim 1350, which surrounds a recess 1352. The various functional elements of the projection module 1300 are arranged within this recess 1352. A lid 1354 may cover the recess 1352. Figure 3a shows the projection module 1300 without the lid 1354. Figure 3b shows the projection module 1300 including the lid 1354. The lid 1354 may be made of glass and include a metal mask. It may have a first transmission window 1356 for the light pixels P and a second transmission window 1358 for the infrared light from the ToF measurement assembly 1306.

An oblique support 1360 is arranged in the recess 1352. The oblique support 1360 has an inclined surface 1362. The photodetector chip 1330 is attached to the inclined surface 1362.

To have a better view of the photodetector chip 1330, the layer stack 1304 on top of that chip has been omitted from figure 3a. In reality, the beam splitting layer stack 1304 of course covers the entire photodetector chip 1330 and thus the entire inclined surface 1362.

The photodetector chip 1330 is divided into a first half H1, which includes the fourth silicon photomultiplier 1338 and the SPAD array 1324, and a second half H2, which includes the first three silicon photomultipliers 1332, 1334 and 1336.

The SPAD array 1324 may consist of a single row of single photon avalanche diodes, as indicated by the dashed rectangle in figure 3a. Preferably, all the SPADs of this single row are at the same vertical distance from the lower surface of the lid 1354. This can simplify the time-of-flight based 3D imaging since it minimises differences in path length from one SPAD pixel to the next.

The four laser diodes 1312, 1314, 1316 and 1322 are arranged in a facing relationship with respect to the inclined support 1360. The lasers are arranged in such a manner in the recess 1352 that the laser beams propagate in a direction parallel to the bottom of the recess 1352. In this configuration, the inclined surface 1362 of the support 1360 makes a 45° angle with the bottom of the recess 1352 such that the light beam components reflected off the beam splitting layer stack 1304 (not shown) can leave the projection module 1300 in a direction perpendicular to the plane defined by the lid 1354.

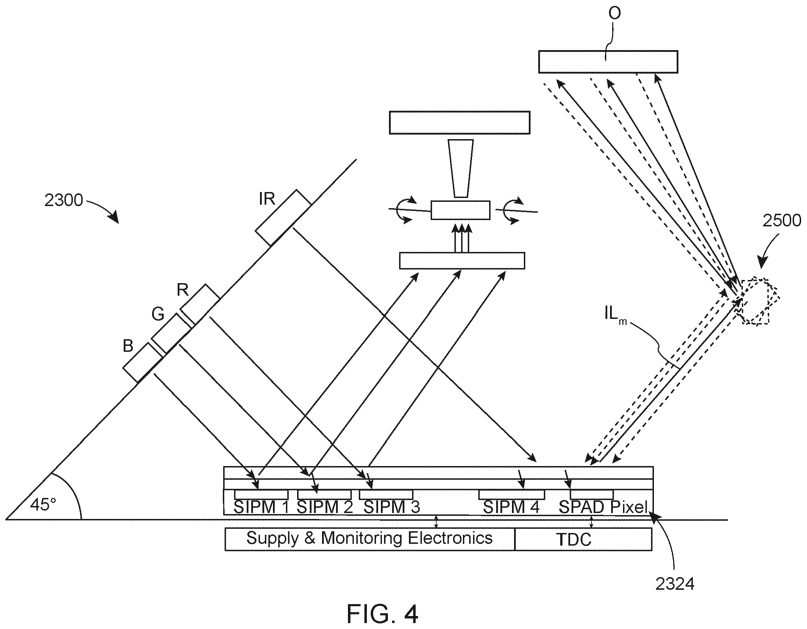

With reference to figure 4, we will now describe a second embodiment 2300 of the projection module according to the present disclosure. The second embodiment 2300 is in many ways similar to the first embodiment 1300 shown in figures 1 to 3. In the following, we will only describe the differences with respect to the first embodiment. Regarding the similarities, reference is made to the previous description of the first embodiment.

The second embodiment 2300 is different from the first embodiment 1300 in that the TOF photodetector 2324 consists of a single SPAD. Furthermore, the TOF measurement assembly further comprises a TOF light scanning device 2500 for scanning the main beam component ILm over the external object O to obtain a 3D image thereof. The TOF light scanning device 2500 may be a micro-electromechanical system or MEMS with a scanning mirror. This variant has the advantage that it allows reducing the size of the TOF photodetector 2324.

Summarising, the light pixel projection modules of the present disclosure have in particular the following technical advantages:
- an integrated time-of-flight measurement assembly for 3D imaging of external objects;
- automatic correction of the brightness of projected images via real-time monitoring of the light intensity of the laser light sources;
- infrared stray light monitoring for improved noise rejection during time-of-flight measurements;
- simplified time-of-flight measurements by using a fraction of the ToF light beam as a trigger for time interval measurements;
- very compact packaging concept with a multi-wavelength laser illumination block and a highly sensitive real-time multi-wavelength light monitoring block integrated into a single package in a face-to-face arrangement.

## Claims

1. A light pixel projection module (1300) for integration into an electronic device, the light pixel projection module (1300) being adapted to emit pixels of light (P) that are to be projected onto a surface (S), the light pixel projection module (1300) comprising:
- a light pixel generating assembly (1302) including a pixel light source;
- a light pixel projection assembly (1304) for projecting a light pixel (P) generated by the light pixel generating assembly; and
- an optical time-of-flight - ToF - measurement assembly (1306) for measuring a distance between the projection module (1300) and an external object (O), the ToF measurement assembly (1306) including:
a) a ToF light source (1322) for emitting light, which is to be directed onto the external object (O) and reflected off the external object;
b) a beam splitting optical device (1304) for splitting an incident light beam (IL) into a reflected main beam component (ILm) and a transmitted and attenuated secondary beam component (ILs); and
c) an APD-based ToF photodetector (1324) for light detection;
**characterised in that** the beam splitting optical device (1304) is arranged in the optical path of light beams (IL) emitted by the ToF light source (1322) such that it splits each light beam (IL) emitted by the ToF light source into:
i) the reflected main beam component (ILm) leaving the module (1300) and heading towards the external object (O); and
ii) the transmitted and attenuated secondary beam component (ILs) remaining within the module (1300) and hitting the ToF photodetector (1324),
and wherein the beam splitting optical device (1304) also acts as the light pixel projection assembly such that light beams (BL, GL, RL) emitted by the pixel light source (1302) to generate the light pixel (P) are each split by the beam splitting optical device (1304) into a reflected main beam component (BLm, GLm, RLm) leaving the module (1300) and a transmitted and attenuated secondary beam component (BLs, GLs, RLs) remaining within the module (1300).

2. The projection module (1300) of claim 1, wherein the beam splitting optical device (1304) is a layer stack with an upper mirror section (1318) acting as a largely reflecting mirror, and a lower light attenuating section (1320) arranged underneath the upper mirror section.

3. The projection module (1300) of claim 2, wherein the layer stack (1304) is deposited over the active surface area of the ToF photodetector (1324).

4. The projection module (1300) of claim 2 or 3, wherein the upper mirror section (1318) is an optical longpass filter with a cutoff wavelength that is higher than the maximum wavelength of the light beams (IL) emitted by the ToF light source (1322) such that the secondary beam component (ILs) of a light beam split by the beam splitting optical device (1304) amounts to no more than 5% of the light beam's overall intensity.

5. The projection module (1300) of any one of claims 2 to 4, wherein the lower light attenuating section (1320) is a neutral density filter, preferably with a fractional transmittance of no more than 0.01%.

6. The projection module (1300) of any one of the previous claims, further comprising a package (1348), which houses the elements of the projection module (1300), the ToF light source (1322) and the ToF photodetector (1324) thus sharing the same package.

7. The projection module (1300) of any one of the previous claims, further comprising a photodetector assembly (1308) for detecting a drift in the irradiance of the pixel light source (1302) and/or the ToF light source (1322).

8. The projection module (1300) of claim 7, wherein the photodetector assembly (1308) includes one or more silicon photomultipliers (1332).

9. The projection module (1300) of claim 7 or 8, wherein the beam splitting optical device (1304) covers both the photodetector assembly (1308) and the ToF photodetector (1324).

10. The projection module (1300) of any one of the previous claims, wherein the ToF photodetector (1324) includes at least one single photon avalanche diode or SPAD.

11. The projection module (2300) of claim 10, wherein the ToF photodetector (2324) consists of a single SPAD and the ToF measurement assembly further comprises a ToF light scanning device (2500) for scanning the main beam component (ILm) over the external object (O) to obtain a 3D image thereof.

12. An image projection device (1315) for projecting a pixelated image onto a surface (S), the image projection device (1315) including the projection module (1300) of any one of the previous claims and a light scanning module (1313) for distributing the light pixels (P) projected by the projection module onto different parts of the surface (S), thus creating the pixelated image.

## Patentansprüche

1. Lichtpixel-Projektionsmodul (1300) zur Integration in ein elektronisches Gerät, wobei das Lichtpixel-Projektionsmodul (1300) dazu ausgebildet ist, Lichtpixel (P) zu emittieren, die auf eine Oberfläche (S) projiziert werden sollen, wobei das Lichtpixel-Projektionsmodul (1300) Folgendes umfasst:
- eine Lichtpixel-Erzeugungsanordnung (1302), die eine Pixellichtquelle aufweist;
- eine Lichtpixel-Projektionsanordnung (1304) zum Projizieren eines von der Lichtpixel-Erzeugungsanordnung erzeugten Lichtpixels (P); und
- eine optische Laufzeitmessanordnung (1306) zum Messen eines Abstands zwischen dem Projektionsmodul (1300) und einem externen Objekt (O), wobei die optische Laufzeitmessanordnung (1306) Folgendes aufweist:
a) eine ToF-Lichtquelle (1322) zum Emittieren von Licht, das auf das externe Objekt (O) gerichtet und von dem externen Objekt reflektiert werden soll;
b) eine strahlteilende optische Vorrichtung (1304) zum Aufteilen eines einfallenden Lichtstrahls (IL) in eine reflektierte Hauptstrahlkomponente (ILm) und eine transmittierte und abgeschwächte Sekundärstrahlkomponente (ILs); und
c) ein APD-basierter ToF-Photodetektor (1324) zur Lichtdetektion;
**dadurch gekennzeichnet, dass** die strahlteilende optische Vorrichtung (1304) im optischen Pfad von durch die ToF-Lichtquelle (1322) emittierten Lichtstrahlen (IL) angeordnet ist, derart, dass sie jeden von der ToF-Lichtquelle emittierten Lichtstrahl (IL) aufteilt in:
i) die reflektierte Hauptstrahlkomponente (ILm), die das Modul (1300) verlässt und sich zu dem externen Objekt (O) hin bewegt; und
ii) die transmittierte und abgeschwächte Sekundärstrahlkomponente (ILs), die innerhalb des Moduls (1300) verbleibt und auf den ToF-Photodetektor (1324) auftrifft,
und wobei die strahlteilende optische Vorrichtung (1304) zudem als die Lichtpixel-Projektionsanordnung wirkt, derart, dass von der Pixellichtquelle (1302) zur Erzeugung des Lichtpixels (P) emittierte Lichtstrahlen (BL, GL, RL) jeweils durch die strahlteilende optische Vorrichtung (1304) aufgeteilt werden in eine reflektierte Hauptstrahlkomponente (BLm, GLm, RLm), die das Modul (1300) verlässt, und eine transmittierte und abgeschwächte Sekundärstrahlkomponente (BLs, GLs, RLs), die innerhalb des Moduls (1300) verbleibt.

2. Projektionsmodul (1300) nach Anspruch 1, wobei die strahlteilende optische Vorrichtung (1304) ein Schichtstapel mit einem oberen Spiegelabschnitt (1318), der als ein weitgehend reflektierender Spiegel wirkt, und einem unteren lichtabschwächenden Abschnitt (1320), der unterhalb des oberen Spiegelabschnitts angeordnet ist, ist.

3. Projektionsmodul (1300) nach Anspruch 2, wobei der Schichtstapel (1304) über der aktiven Oberfläche des ToF-Photodetektors (1324) abgeschieden ist.

4. Projektionsmodul (1300) nach Anspruch 2 oder 3, wobei der obere Spiegelabschnitt (1318) ein optischer Langpassfilter mit einer Grenzwellenlänge ist, die höher ist als die maximale Wellenlänge der von der ToF-Lichtquelle (1322) emittierten Lichtstrahlen (IL), derart, dass die Sekundärstrahlkomponente (ILs) eines durch die strahlteilende optische Vorrichtung (1304) aufgeteilten Lichtstrahls nicht mehr als 5 % der Gesamtintensität des Lichtstrahls beträgt.

5. Projektionsmodul (1300) nach einem der Ansprüche 2 bis 4, wobei der untere lichtabschwächende Abschnitt (1320) ein Neutraldichtefilter ist, vorzugsweise mit einer fraktionellen Transmission von nicht mehr als 0,01 %.

6. Projektionsmodul (1300) nach einem der vorhergehenden Ansprüche, ferner umfassend ein Gehäuse (1348), das die Elemente des Projektionsmoduls (1300) aufnimmt, wobei die ToF-Lichtquelle (1322) und der ToF-Photodetektor (1324) somit dasselbe Gehäuse gemeinsam nutzen.

7. Projektionsmodul (1300) nach einem der vorhergehenden Ansprüche, ferner umfassend eine Photodetektoranordnung (1308) zum Erfassen einer Drift der Bestrahlungsstärke der Pixellichtquelle (1302) und/oder der ToF-Lichtquelle (1322).

8. Projektionsmodul (1300) nach Anspruch 7, wobei die Photodetektoranordnung (1308) einen oder mehrere Silizium-Photomultiplier (1332) aufweist.

9. Projektionsmodul (1300) nach Anspruch 7 oder 8, wobei die strahlteilende optische Vorrichtung (1304) sowohl die Photodetektoranordnung (1308) als auch den ToF-Photodetektor (1324) bedeckt.

10. Projektionsmodul (1300) nach einem der vorhergehenden Ansprüche, wobei der ToF-Photodetektor (1324) mindestens eine Einzelphotonen-Avalanche-Diode oder SPAD aufweist.

11. Projektionsmodul (2300) nach Anspruch 10, wobei der ToF-Photodetektor (2324) aus einer einzelnen SPAD besteht und die optische Laufzeitmessanordnung ferner eine ToF-Lichtabtastvorrichtung (2500) zum Abtasten der Hauptstrahlkomponente (ILm) über das externe Objekt (O) umfasst, um ein 3D-Bild davon zu erhalten.

12. Bildprojektionsvorrichtung (1315) zum Projizieren eines pixelierten Bildes auf eine Oberfläche (S), wobei die Bildprojektionsvorrichtung (1315) das Projektionsmodul (1300) nach einem der vorhergehenden Ansprüche und ein Lichtabtastmodul (1313) zum Verteilen der von dem Projektionsmodul projizierten Lichtpixel (P) auf verschiedene Teile der Oberfläche (S) aufweist, wodurch das pixelierte Bild erzeugt wird.

## Revendications

1. Module de projection de pixels lumineux (1300) pour l'intégration dans un dispositif électronique, le module de projection de pixels lumineux (1300) étant adapté pour émettre des pixels lumineux (P) devant être projetés sur une surface (S), le module de projection de pixels lumineux (1300) comprenant :
- un ensemble de génération de pixels lumineux (1302) comportant une source de lumière de pixel ;
- un ensemble de projection de pixels lumineux (1304) destiné à projeter un pixel lumineux (P) généré par l'ensemble de génération de pixels lumineux ; et
- un ensemble de mesure optique du temps de vol (1306) destiné à mesurer une distance entre le module de projection (1300) et un objet externe (O), l'ensemble de mesure optique du temps de vol (1306) comportant :
a) une source de lumière ToF (1322) destinée à émettre de la lumière, qui doit être dirigée vers l'objet externe (O) et réfléchie par l'objet externe ;
b) un dispositif optique de division de faisceau (1304) destiné à diviser un faisceau lumineux incident (IL) en une composante de faisceau principal réfléchie (ILm) et une composante de faisceau secondaire transmise et atténuée (ILs) ; et
c) un photodétecteur ToF (1324) à base d'APD pour la détection de lumière ;
**caractérisé en ce que** le dispositif optique de division de faisceau (1304) est agencé dans le trajet optique de faisceaux lumineux (IL) émis par la source de lumière ToF (1322) de telle sorte qu'il divise chaque faisceau lumineux (IL) émis par la source de lumière ToF en :
i) la composante de faisceau principal réfléchie (ILm) quittant le module (1300) et se dirigeant vers l'objet externe (O) ; et
ii) la composante de faisceau secondaire transmise et atténuée (ILs) restant à l'intérieur du module (1300) et frappant le photodétecteur ToF (1324),
et dans lequel le dispositif optique de division de faisceau (1304) agit également en tant qu'ensemble de projection de pixels lumineux, de telle sorte que des faisceaux lumineux (BL, GL, RL) émis par la source de lumière de pixel (1302) pour générer le pixel lumineux (P) sont chacun divisés par le dispositif optique de division de faisceau (1304) en une composante de faisceau principal réfléchie (BLm, GLm, RLm) quittant le module (1300) et une composante de faisceau secondaire transmise et atténuée (BLs, GLs, RLs) restant à l'intérieur du module (1300).

2. Module de projection (1300) selon la revendication 1, dans lequel le dispositif optique de division de faisceau (1304) est un empilement de couches comportant une section de miroir supérieure (1318) agissant en tant que miroir largement réfléchissant, et une section d'atténuation de lumière inférieure (1320) agencée au-dessous de la section de miroir supérieure.

3. Module de projection (1300) selon la revendication 2, dans lequel l'empilement de couches (1304) est déposé sur la zone de surface active du photodétecteur ToF (1324).

4. Module de projection (1300) selon la revendication 2 ou 3, dans lequel la section de miroir supérieure (1318) est un filtre optique passe-long ayant une longueur d'onde de coupure supérieure à la longueur d'onde maximale des faisceaux lumineux (IL) émis par la source de lumière ToF (1322), de telle sorte que la composante de faisceau secondaire (ILs) d'un faisceau lumineux divisé par le dispositif optique de division de faisceau (1304) s'élève à au plus 5 % de l'intensité globale du faisceau lumineux.

5. Module de projection (1300) selon l'une quelconque des revendications 2 à 4, dans lequel la section d'atténuation de lumière inférieure (1320) est un filtre à densité neutre, de préférence ayant une transmittance fractionnaire d'au plus 0,01 %.

6. Module de projection (1300) selon l'une quelconque des revendications précédentes, comprenant en outre un boîtier (1348) qui loge les éléments du module de projection (1300), la source de lumière ToF (1322) et le photodétecteur ToF (1324) partageant ainsi le même boîtier.

7. Module de projection (1300) selon l'une quelconque des revendications précédentes, comprenant en outre un ensemble photodétecteur (1308) destiné à détecter une dérive de l'irradiance de la source de lumière de pixel (1302) et/ou de la source de lumière ToF (1322).

8. Module de projection (1300) selon la revendication 7, dans lequel l'ensemble photodétecteur (1308) comporte un ou plusieurs photomultiplicateurs en silicium (1332).

9. Module de projection (1300) selon la revendication 7 ou 8, dans lequel le dispositif optique de division de faisceau (1304) recouvre à la fois l'ensemble photodétecteur (1308) et le photodétecteur ToF (1324).

10. Module de projection (1300) selon l'une quelconque des revendications précédentes, dans lequel le photodétecteur ToF (1324) comporte au moins une photodiode à avalanche à photon unique ou SPAD.

11. Module de projection (2300) selon la revendication 10, dans lequel le photodétecteur ToF (2324) est constitué d'un seul SPAD et l'ensemble de mesure optique du temps de vol comprend en outre un dispositif de balayage de lumière ToF (2500) destiné à balayer la composante de faisceau principal (ILm) sur l'objet externe (O) pour obtenir une image 3D de celui-ci.

12. Dispositif de projection d'image (1315) destiné à projeter une image pixélisée sur une surface (S), le dispositif de projection d'image (1315) comportant le module de projection (1300) selon l'une quelconque des revendications précédentes et un module de balayage de lumière (1313) destiné à répartir les pixels lumineux (P) projetés par le module de projection sur différentes parties de la surface (S), créant ainsi l'image pixélisée.
